# EUROPEAN PATENT SPECIFICATION

(11) **EP 2 841 727 B1**
(45) Date of publication and mention of the grant of the patent: **14.09.2016**
(21) Application number: 12756539.8
(22) Date of filing: 27.07.2012
(51) Int. Cl.: F01N 13/14, F01N 13/00

(54) **AFTERTREATMENT MODULE WITH SENSOR MOUNTING ARRANGEMENT**
NACHBEHANDLUNGSMODUL MIT SENSORMONTAGEANORDNUNG
MODULE DE POST-TRAITEMENT DOTÉ D'UN AGENCEMENT DE MONTAGE DE CAPTEUR

(30) Priority: 24.04.2012 GB 201207201
(43) Date of publication of application: 04.03.2015
(73) Proprietor: Perkins Engines Company Limited, Cambridgeshire PE1 5FQ (GB)
(72) Inventor: NIAZ, Naseer A., Peterborough Cambridgeshire PE1 4RD (GB)
(74) Representative: BRP Renaud & Partner mbB Rechtsanwälte Patentanwälte Steuerberater
(86) International application number: PCT/GB2012/051840
(87) International publication number: WO 2013/160634

(56) References cited:
- EP-A2- 0 722 040
- WO-A1-2011/118527

## Description

### Technical Field

This disclosure is directed to an aftertreatment module having a sensor mounting arrangement.

### Background

Engines, for example internal combustion engines burning gasoline, diesel, or biofuel, output various harmful substances which must be treated to meet current and future emissions legislation. Most commonly, such substances comprise hydrocarbons (HC), carbon monoxides (CO), mono-nitrogen oxides (NOx), and particulate matter such as carbon (C), a constituent of soot. Some of those substances may be reduced by careful control of the operating conditions of the engine, but usually it is necessary to provide an aftertreatment module downstream of the engine to treat at least some of the substances entrained in the exhaust gas.

Various apparatus for reducing and/or eliminating constituents in emissions are known. For example, it is known to provide an oxidation device, such as a diesel oxidation catalyst, to reduce or to eliminate hydrocarbons (HC) and/or carbon monoxide (CO). Oxidation devices generally include a catalyst to convert those substances into carbon dioxide and water, which are significantly less harmful.

As a further example, aftertreatment modules may include filtration devices to restrict the particulates present in the exhaust gas from being output to atmosphere. The soot collected in the filtration device must later be removed to maintain the efficiency of the filtration device. The methods by which soot may be removed from the filtration device are well known in the art and may generally be referred to as regeneration, which is carried out at elevated temperatures.

In addition, it is known to reduce or eliminate mono-nitrogen oxides (NOx) in diesel combustion emissions by conversion to diatomic nitrogen (N₂) and water (H₂O) by catalytic reaction with chemicals such as ammonia (NH₃) entrained in the exhaust gas. Generally, ammonia is not present in exhaust gas and must therefore be introduced upstream of a catalyst, typically by injecting a urea solution into the exhaust gas which decomposes into ammonia at sufficiently high temperatures.

By these methods, engine emissions can be cleaned, meaning that a proportion of the harmful substances which would otherwise be released to atmosphere are instead converted to carbon dioxide (CO₂), nitrogen (N₂) and water (H₂O).

Aftertreatment modules may be provided with one or more sensors for determining one or more conditions within the flow path in the module, such as temperature or quantity of NOx. Parts of the sensors may need to be thermally isolated from the heat of the exhaust gas and, at the same time, also be protected from environmental and mechanical damage, for example due to water collecting at the mounting point which may freeze during machine shutdown. The sensors must be mounted in a secure, insulated, and sealed manner to ensure that they will not easily detach, overheat, or provide a fluid leakage path. Additionally, it is preferable for the sensors to be mounted to the module in a manner which allows for some misalignment of the various features, as for example in EP2551483.

### Summary

According to one aspect of the present disclosure, there is provided an aftertreatment module comprising: a conduit defining a flow path and an aperture into the flow path; a shield arranged at least partway around the conduit and spaced therefrom, the shield including an opening in registration with the aperture; a boss provided on the conduit and having a through-hole in registration with the aperture; a sensor disposed within the boss so as to extend at least partway into the flow path; and a spacer arranged around the boss; and wherein the sensor extends through the opening and the shield further comprises an inner portion for engagement with the spacer, said space being made from a compressible material.

One exemplary embodiment of an aftertreatment module having a sensor mounting arrangement is as described with reference to, and as shown in the accompanying drawings.

### Brief Description of the Drawings

Figure 1 is a perspective view of an aftertreatment module comprising a sensor mounting arrangement according to the present disclosure;
Figure 2 is a part-cutaway view of the aftertreatment module of Figure 1;
Figure 3 shows a sensor mounted in the sensor mounting arrangement of the aftertreatment module of Figures 1 and 2; and

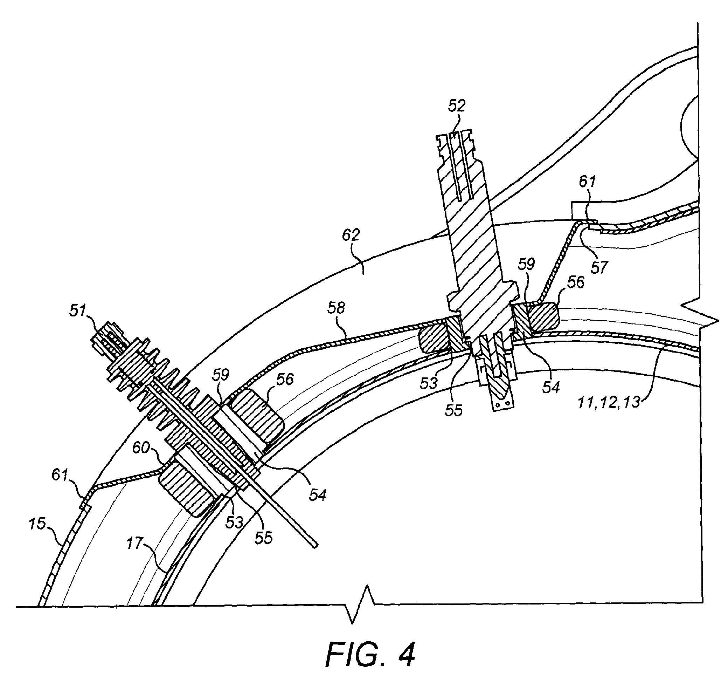

Figure 4 shows two sensors mounted in the sensor mounting arrangement of the aftertreatment module of Figures 1 and 2.

### Detailed Description

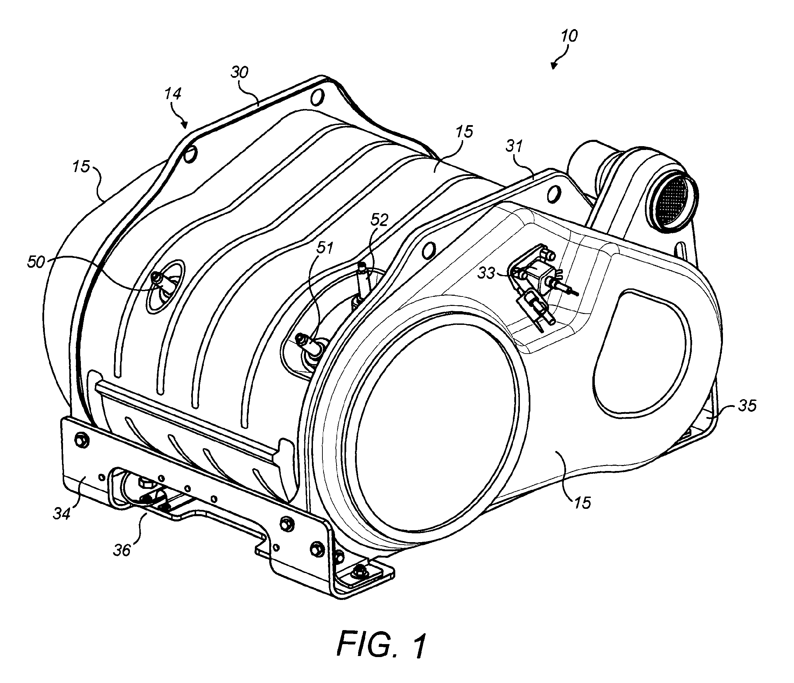

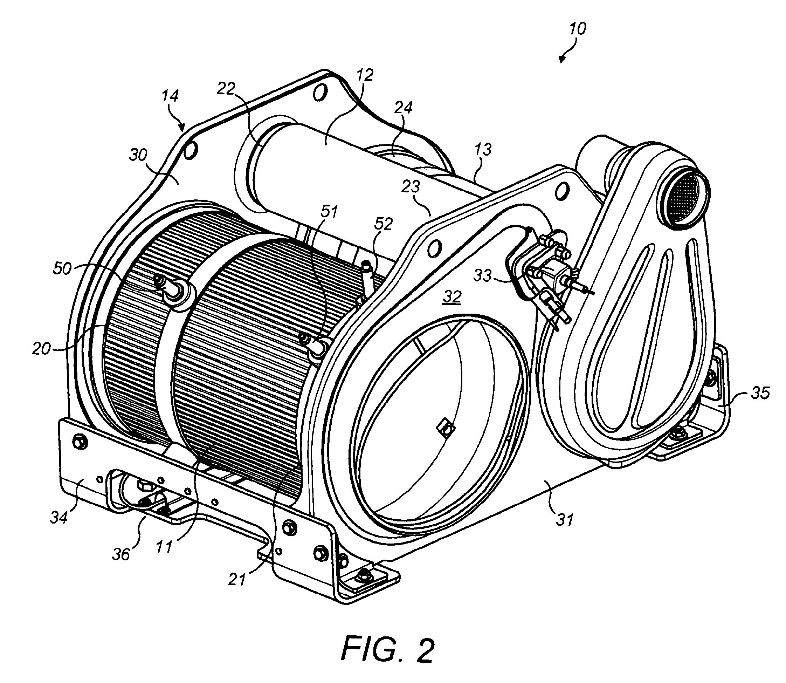

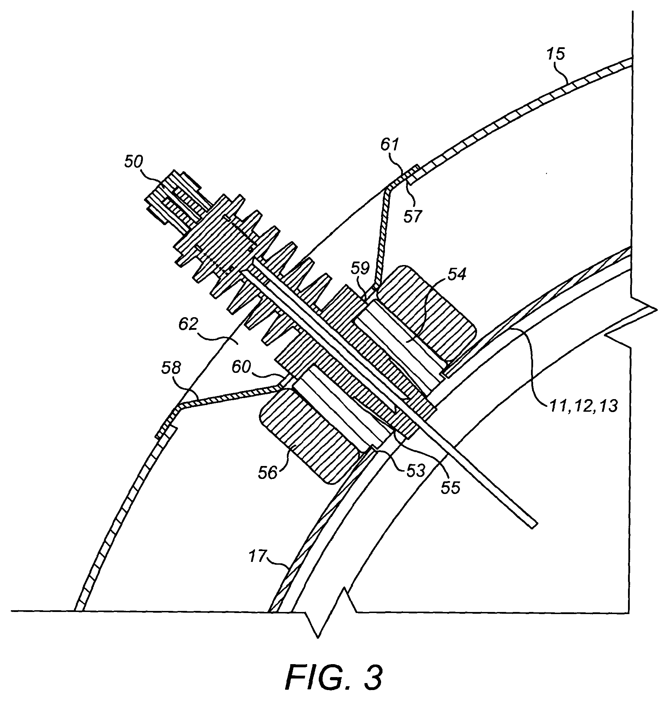

Figures 1 and 2 illustrates an aftertreatment module 10 for an internal combustion engine. The aftertreatment module 10 may comprise a first conduit 11, a second conduit 12, and a third conduit 13, collectively defining a flow path (not shown). There may also be provided a support structure 14 supporting the conduits 11,12,13. A shield 15 (see Figures 2 and 3) may be arranged at least partway around at least one of the conduits and spaced therefrom. The shield 15 may function to protect the aftertreatment module 10 from environmental and/or mechanical damage.

The first, second and third conduits 11,12,13 may be elongate, having an axis of elongation, and may have a substantially constant cross-section along the axis of elongation. The first, second and third conduits 11,12,13 may be substantially cylindrical. The first conduit 11 may comprise a first end 20 providing an inlet to the conduit 11 and a second end 21 providing an outlet to the conduit 11. The second conduit 12 may comprise a first end 22 providing an outlet to the conduit 20 and a second end 23 providing an inlet to the conduit 12. The third conduit 13 may comprise a first end 24 providing an inlet to the conduit 13 and a second end (not shown) providing an outlet to the conduit 13.

The support structure 14 may comprise a first support member 30 and an opposing second support member 31. The conduits 11,12,13 may extend between the support members 30,31. The first conduit 11 may be coupled to the second conduit 12 via a first end coupling forming a flow hood 32 for fluidly connecting the outlet of the first conduit 11 to the inlet of the second conduit 12. The flow hood 32 may comprise an injector module 33. The second conduit 12 may be coupled to the third conduit 13 via a second end coupling (not shown) for fluidly connecting the outlet of the second conduit 12 to the inlet of the third conduit 13.There may also be a shield 15 attached to each support member 30,31 and arranged to overlie the respective flow hood 32.

The support structure 14 may further comprise a first brace 34 and a second brace 35. Each of the first and second braces 34,35 may comprise a longitudinal beam possibly having a generally L-shaped cross section. At least one of the braces may include a cut-out arranged partway between its ends so as to define two mutually perpendicular and unconnected portions. Each brace 34,35 therefore may comprise a rectangular plate with an aperture 36 at the centre, each rectangular plate having a substantially 90° fold in a direction parallel to a longitudinal axis of the beam 34,35 such that the fold intersects the aperture 36.

The first and second support members 30,31 and the first and second braces 34,35 may together form a rigid rectangular structure (not shown) which may serve a purpose of holding the three conduits 11,12,13 relative to one another whilst accommodating differential expansion and/or contraction of components relative to each other.

Within the flow path of the aftertreatment module there may be located a diesel oxidation catalyst (DOC) module (not shown), a diesel particulate filter (DPF) module (not shown), an injector module 33, a mixer module (not shown), a selective catalyst reduction (SCR) module (not shown), and an ammonia oxidation catalyst (AMOX) module (not shown).

The DOC module may be located in a first portion of the first conduit 11 towards the first inlet end 20 of the first conduit 11. The DPF module may be located in a second portion of the first conduit 11 towards the second outlet end 21 of the first conduit 11. The flow hood 32 may provide a fluid flow path from the second end 21 of the first conduit 11 to the second end 23 of the second conduit 12. The flow hood 32 may comprise the injector module 33.

The mixer module (not shown) may be located in the second conduit 12. The mixer module may be configured to mix a fluid injected by the injector module 33 with a fluid arriving from the first conduit 11. The mixer module may comprise multiple features, such as interspersed fins, which may give rise to an even blend of the injected fluid with the fluid from the first conduit 11. The second end coupling (not shown) may provide a fluid flow path from the first end 22 of the second conduit 12 to the first end 24 of the third conduit 13.

The SCR module (not shown) may be located in a first portion of the third conduit 13, and possibly towards the first end 24 of the third conduit 13. The SCR module may comprise a catalyst surface intended to catalyse a reaction to occur between the two fluids mixed in the mixer module and output by the diffuser. The AMOX module (not shown) may both be located in a second portion of the third conduit 13, and possibly towards the second end (not shown) of the third conduit 13. The AMOX module may comprise a catalyst which may catalyse a reaction of one or more of the products output from the SCR module.

The aftertreatment module 10 may comprise one or more sensors for sensing one or more conditions in the aftertreatment module 10, such as temperature or quantity of NOx. Such sensors may need to be thermally isolated from the heat of the exhaust gas and, at the same time, also be protected from environmental and mechanical damage. For example, this may be due to water collecting at the mounting point and potentially freezing during machine shutdown. The sensors must be mounted in a secure, insulated, and sealed manner to ensure that they will not easily detach, overheat, or provide a fluid leakage path. Additionally, the sensors must be mounted to the module in a manner which allows for some misalignment of the various features.

One sensor 50, as shown in Figure 2, or a plurality of sensors 51, 52, as shown in Figures 1 and 3, may be mounted in an aperture 53 in the wall of a conduit 11,12,13. The mounting is such that the sensor 50,51,52 may penetrate the conduit 11,12,13, whilst those elements of the sensor which need not be located within a volume to be sensed (i.e. electronic components) may be located on an exterior surface 17 of the conduit 11,12,13. In this manner, sensitive elements of the sensor 50,51,52 can be located away from high temperatures likely to occur inside the conduit.

A boss 54 may be provided on the conduit 11,12,13, the boss 54 having a through-hole 55 arranged substantially in registration with the aperture 53. The boss 54 may be welded to the conduit 11,12,13, may be secured to the conduit 11,12,13 by any other suitable means, or may be formed as an integral part of the conduit 11,12,13. The sensor 50,51,52 may be disposed within the boss 54 so as to extend partway into the flow path.

A spacer 56 may be arranged around the boss 54. The spacer 56 may be formed of a dense wire mesh, which may be compressible. Alternatively, the spacer 56 may be formed of an insulating material, or any other suitable material. The spacer 56 may be cylindrical or of any other suitable shape or structure.

The shield 15 may include an opening 57 in registration with the aperture 53, to accommodate the sensor 50,51,52. A cap 58 may be provided to at least partially seal the opening 57 in the shield 15. The cap 58 may have an aperture 59 through which the sensor 50,51,52 may extend, an inner portion 60 for engagement with the spacer 56, and an outer portion 61 for engagement with the shield 15. The cap 58 may be welded to the shield 15. The cap 58 may have an exterior profile which defines a recess 62 in the shield 15. The recess 62 may form an indentation that may allow for improved cooling of the sensor 50,51,52. The recess 62 may be cup-shaped. The exterior profile and orientation of the recess 62 may be such that any fluid which falls into the recess 62 will tend to move out of the recess 62 as a consequence of gravity. This might be achieved by the profile of the recess 62 being monotonically decreasing towards a lowest point, when the conduit 11,12,13 is in an upright position. By monotonically decreasing, it may be meant that the recess 62 includes no local low points but rather that the recess 62 comprises a single high point from which, and a single low point towards which, fluid may flow under gravity. There may be no local low points in the recess 62 which might otherwise act as a reservoir for fluid which could not escape from the recess 62 under gravity, other than the possibility of small gaps between the sensor 50,51,52 and the cap inner portion 60 due to manufacturing tolerances.

Alternatively, the shield 15 may mate directly with the spacer 56, which would reduce the need for a separate cap 58. In such an arrangement, the shield 15 may be profiled in a similar manner to the cap 58 as described above.

A similar mounting arrangement using a spacer 56 may be used for the mounting of the injector unit 33 with respect to the flow hood 32 (acting as a conduit 11,12,13) and the shield 15. A similar mounting arrangement using a spacer 56 may additionally be used for any other device which may need to be in communication with the flow path.

The boss 54, shield, 15, and cap 58 may all be made of stainless steel.

### Industrial Applicability

The aftertreatment module 10 having the above described sensor mounting arrangement has industrial applicability in the field of internal combustion engines, and particularly in the field of diesel internal combustion engines.

When the aftertreatment module is in use, air between the conduits 11,12,13 and the shield 15 may become heated by the exhaust gases in the aftertreatment module 10, causing it to expand and vent out of any gaps in the shield 15. Hot air jetting out onto the components of the sensors 50,51,52 which are external to the conduits 11,12,13 may cause damage to the sensors 50,51,52. The spacer 56 may act as at least a partial seal to prevent or minimise hot air located within the space between the conduits 11,12,13 and the shield 15 from jetting out through the cap 58 in the vicinity of the sensors 50,51,52 between the boss 54 and the cap 58, thereby avoiding damage to the sensors 50,51,52. The compressibility of the spacer 56 may allow it to take up tolerance compensation between the boss 54, the shield 15, and the cap 58.

## Claims

1. An aftertreatment module (10) comprising:
a conduit (11,12,13) defining a flow path and an aperture (53) into the flow path;
a shield (15) arranged at least partway around the conduit (11,12,13) and spaced therefrom, the shield (15) including an opening (57) in registration with the aperture (53);
a boss (54) provided on the conduit (11,12,13) and having a through-hole (55) in registration with the aperture (53);
a sensor (50,51,52) disposed within the boss (54) so as to extend at least partway into the flow path; and
a spacer (56) arranged around the boss (54); and
wherein the sensor (50,51,52) extends through the opening (57) and the shield (15) further comprises an inner portion (60) for engagement with the spacer (56); **characterised in that**
the spacer (56) is made from a compressible material.

2. An aftertreatment module (10) according to claim 1, wherein the spacer (56) is made from a dense wire mesh.

3. An aftertreatment module (10) according to claim 1, wherein the spacer (56) is made from an insulating material.

4. An aftertreatment module (10) according to any one of the preceding claims, wherein the shield (15) comprises a cap portion (58) comprising an aperture (53) through which the sensor (50,51,52) extends, an inner portion (60) for engagement with the spacer (56), and an outer portion (61) for engagement with the shield (15).

5. An aftertreatment module (10) according to claim 4, wherein the cap portion (58) comprises a recess (62) in an exterior profile of the shield (15).

6. An aftertreatment module (10) according to claim 5, wherein the recess (62) is cup-shaped.

7. An aftertreatment module (10) according to claim 5 or claim 6, wherein the exterior profile of the recess (62) monotonically decreases towards a lowest point.

8. An aftertreatment module (10) according to any one of claims 4 to 7, wherein the spacer (56) forms at least a partial seal between the boss (54) and the cap portion (58).

9. An aftertreatment module (10) according to any one of the preceding claims, wherein the sensor (50,51,52) is disposed within the boss (54) such that non-sensing elements of the sensor (50,51,52) are located exterior to the conduit (11,12,13).

10. An aftertreatment module (10) according to any one of the preceding claims, wherein the boss (54) is welded to the conduit (11,12,13).

11. An aftertreatment module (10) according to any one of the preceding claims, wherein the boss (54) is made of stainless steel.

12. An aftertreatment module (10) according to any one of the preceding claims, wherein the shield (15) is made of stainless steel.

13. An aftertreatment module (10) according to any one of claims 9 to 12, wherein the cap (58) is made of stainless steel.

## Patentansprüche

1. Nachbehandlungsmodul (10), umfassend:
eine Rohrleitung (11, 12, 13), die einen Strömungsweg und eine Öffnung (53) in den Strömungsweg definiert;
einen Schild (15), der zumindest teilweise rund um das Rohr (11, 12, 13) und mit Abstand davon angeordnet ist, wobei der Schild (15) eine Öffnung (57) eingerastet in die Öffnung (53) umfasst;
einen Vorsprung (54), der auf der Rohrleitung (11, 12, 13) vorgesehen ist und ein Durchgangsloch (55) im Eingriff mit der Öffnung (53) hat;
einen Sensor (50, 51, 52), der innerhalb des Vorsprungs (54) angeordnet ist, um sich so zumindest teilweise in den Strömungsweg hinein zu erstrecken; und
einen Abstandshalter (56), der rund um den Vorsprung (54) angeordnet ist; und
wobei der Sensor (50, 51, 52) sich durch die Öffnung (57) erstreckt und der Schild (15) ferner einen inneren Teil (60) für den Eingriff mit dem Abstandshalter (56) umfasst, **dadurch gekennzeichnet, dass**
der Abstandshalter (56) aus einem kompressiblen Material hergestellt ist.

2. Nachbehandlungsmodul (10) nach Anspruch 1, wobei der Abstandshalter (56) aus einem dichten Drahtgeflecht hergestellt ist.

3. Nachbehandlungsmodul (10) nach Anspruch 1, wobei der Abstandhalter (56) aus einem isolierenden Material hergestellt ist.

4. Nachbehandlungsmodul (10) nach einem der vorhergehenden Ansprüche, wobei der Schild (15) einen Kappenteil (58) umfasst, der eine Öffnung (53) umfasst, durch die sich der Sensor (50, 51, 52) erstreckt, einen inneren Teil (60) zum Eingriff in den Abstandshalter (56) und einen äußeren Teil (61) für den Eingriff mit dem Schild (15).

5. Nachbehandlungsmodul (10) nach Anspruch 4, wobei der Kappenteil (58) eine Vertiefung (62) in einem äußeren Profil des Schildes (15) umfasst.

6. Nachbehandlungsmodul (10) nach Anspruch 5, wobei die Vertiefung (62) kelchförmig ist.

7. Nachbehandlungsmodul (10) nach Anspruch 5 oder 6, wobei das äußere viel der Vertiefung (62) sich monoton zu einem niedrigsten Punkt hin verringert.

8. Nachbehandlungsmodul (10) nach einem der Ansprüche 4 bis 7, wobei der Abstandshalter (56) zumindest eine Teildichtung zwischen dem Vorsprung (54) und dem Kartenteil (58) bildet.

9. Nachbehandlungsmodul (10) nach einem der vorhergehenden Ansprüche, wobei der Sensor (50, 51, 52) innerhalb des Vorsprungs (54) derart angeordnet ist, dass nichtabtastende Elemente des Sensors (50, 51, 52) sich außerhalb der Rohrleitung (11, 12, 13) befinden.

10. Nachbehandlungsmodul (10) nach einem der vorhergehenden Ansprüche, wobei der Vorsprung (54) an die Rohrleitung (11, 12, 13) angeschweißt ist.

11. Nachbehandlungsmodul (10) nach einem der vorhergehenden Ansprüche, wobei der Vorsprung (54) aus rostfreiem Stahl hergestellt ist.

12. Nachbehandlungsmodul (10) nach einem der vorhergehenden Ansprüche, wobei der Schild (15) aus rostfreiem Stahl hergestellt ist.

13. Nachbehandlungsmodul (10) nach einem der Ansprüche 9 bis 12, wobei die Kappe (58) aus rostfreiem Stahl hergestellt ist.

## Revendications

1. Module de post-traitement (10) comprenant :
un conduit (11, 12, 13) définissant un trajet d'écoulement et une ouverture (53) dans le trajet d'écoulement ;
un blindage (15) aménagé au moins en partie autour du conduit (11, 12, 13) et
espacé de celui-ci, le blindage (15) comprenant une ouverture (57) en registre avec l'ouverture (53) ;
un bossage (54) situé sur le conduit (11, 12, 13) et ayant un trou traversant (55) en registre avec l'ouverture (53) ;
un capteur (50, 51, 52) disposé dans le bossage (54) de manière à s'étendre au moins en partie dans le trajet d'écoulement ; et
un espaceur (56) aménagé autour du bossage (54) ; et
dans lequel le capteur (50, 51, 52) s'étend à travers l'ouverture (57) et le blindage (15) comprend en outre une partie interne (60) pour s'engager sur l'espaceur (56) ; **caractérisé en ce que** :
l'espaceur (56) est constitué d'un matériau compressible.

2. Module de post-traitement (10) selon la revendication 1, dans lequel l'espaceur (56) est constitué d'un treillis métallique dense.

3. Module de post-traitement (10) selon la revendication 1, dans lequel l'espaceur (56) est constitué d'un matériau isolant.

4. Module de post-traitement (10) selon l'une quelconque des revendications précédentes, dans lequel le blindage (15) comprend une partie de recouvrement (58) comprenant une ouverture (53) à travers laquelle le capteur (50, 51, 52) s'étend, une partie interne (60) pour s'engager sur l'espaceur (56) et une partie externe (61) pour s'engager sur le blindage (15).

5. Module de post-traitement (10) selon la revendication 4, dans lequel la partie de recouvrement (58) comprend une cavité (62) dans un profil extérieur du blindage (15).

6. Module de post-traitement (10) selon la revendication 5, dans lequel la cavité (62) est en forme de coupelle.

7. Module de post-traitement (10) selon la revendication 5 ou la revendication 6, dans lequel le profil externe de la cavité (62) diminue de façon monotone vers un point le plus bas.

8. Module de post-traitement (10) selon l'une quelconque des revendications 4 à 7, dans lequel l'espaceur (56) forme au moins un joint étanche partiel entre le bossage (54) et la partie de recouvrement (58).

9. Module de post-traitement (10) selon l'une quelconque des revendications précédentes, dans lequel le capteur (50, 51, 52) est disposé dans le bossage (54) de sorte que les éléments non détecteurs du capteur (50, 51, 52) soient situés à l'extérieur du conduit (11, 12, 13).

10. Module de post-traitement (10) selon l'une quelconque des revendications précédentes, dans lequel le bossage (54) est soudé au conduit (11, 12, 13).

11. Module de post-traitement (10) selon l'une quelconque des revendications précédentes, dans lequel le bossage (54) est constitué d'acier inoxydable.

12. Module de post-traitement (10) selon l'une quelconque des revendications précédentes, dans lequel le blindage (15) est constitué d'acier inoxydable.

13. Module de post-traitement (10) selon l'une quelconque des revendications 9 à 12, dans lequel le recouvrement (58) est constitué d'acier inoxydable.
